# EUROPEAN PATENT APPLICATION

(11) **EP 4 033 525 A2**
(43) Date of publication of application: **27.07.2022**
(21) Application number: 21206419.0
(22) Date of filing: 04.11.2021
(51) Int. Cl.: H01L 23/485, H01L 23/31

(54) **SEMICONDUCTOR STRUCTURE**

(30) Priority: 26.11.2020 US 202063118668 P; 25.10.2021 US 202117510348
(71) Applicant: MEDIATEK INC., Hsin-Chu 300 (TW)
(72) Inventor: HUANG, Pu-Shan, 30078 Hsinchu City (TW)
(74) Representative: Hoefer & Partner Patentanwälte mbB

(57) **Abstract**

A semiconductor structure (1) includes a substrate (100), a passivation layer (110) on the substrate (100), a post-passivation interconnect, PPI, structure on the passivation layer (110), and a polymer layer (130) covering the PPI structure (120) and the passivation layer (110). The PPI structure (120) includes a step structure (125) disposed on the passivation layer (110) and around a lower edge of the PPI structure (120).

## Description

### Cross Reference to Related Applications

This application claims priority from U.S. provisional application No. 63/118,668 filed on November 26, 2020, the disclosure of which is included in its entirety herein by reference.

### Background

The present disclosure relates generally to the field of semiconductor technology. More particularly, the present disclosure relates to a stepped copper post-passivation interconnect (Cu-PPI) structure for stress reduction.

In the formation of wafer-level chip scale package structures, integrated circuit devices such as transistors are formed at a main surface of a semiconductor substrate or wafer. Interconnect structures are then formed over the integrated circuit devices. A metal pad is formed over the interconnect structures. A passivation layer is formed on the metal pad, with the metal pad exposed through an opening in the passivation layer.

A seed layer is then formed on the passivation layer, followed by the formation of post-passivation interconnect (PPI) line and pad. The PPI line and pad may be formed by forming and patterning a photo resist on the seed layer, plating the PPI line and pad in an opening of the photo resist, and then removing the photo resist. The seed layer not covered by the PPI line and pad is then etched away. A polyimide layer is formed over the PPI line and pad, and an under-bump-metallurgy (UBM) layer is formed extending into an opening in the polyimide layer. The UBM layer is electrically connected to the PPI pad. A solder bump is then formed on the UBM layer.

The above-described bumping structure is also known as 1P2M scheme. Although the 1P2M scheme has an advantage of enhanced electric performance due to reduced electric path, it suffers from high stress that concentrates on the passivation layer around the Cu-PPI edge, which may lead to passivation cracking.

### Summary

It is one object of the present invention to provide an improved copper post-passivation interconnect (Cu-PPI) structure in order to solve the above-mentioned prior art problems or shortcomings. Semiconductor structures according to the invention are defined in the independent claims. The dependent claims define preferred embodiments thereof.

One aspect of the invention provides a semiconductor structure comprising a substrate, a passivation layer on the substrate, a post-passivation interconnect (PPI) structure on the passivation layer, and a polymer layer covering the PPI structure and the passivation layer. The PPI structure comprises a step structure disposed on the passivation layer and around a lower edge of the PPI structure.

Preferably, the step structure comprises a lower layer of the PPI structure that protrudes beyond a sidewall of the PPI structure on the passivation layer.

Preferably, the lower layer comprises a titanium layer.

Preferably, the lower layer further comprises a copper on the titanium layer.

Preferably, the semiconductor structure further comprises an input/output (I/O) pad disposed on the substrate, wherein the passivation layer covers the substrate and a perimeter of the I/O pad.

Preferably, the PPI structure comprises a via portion disposed in the passivation layer and in direct contact with the I/O pad, a redistribution layer (RDL) pad disposed over the passivation layer and offset from the I/O pad, and a RDL runner extending on the passivation layer between the via portion and the RDL pad.

Preferably, the PPI structure comprises a copper layer and a titanium layer under the copper layer.

Preferably, the passivation layer comprises silicon nitride.

Preferably, the polymer layer comprises epoxy, polyimide, benzocyclobutene (BCB), or polybenzoxazole (PBO).

Preferably, an opening is formed in the polymer layer to expose at least a portion of the RDL pad.

Preferably, an under-bump-metallurgy (UBM) layer is disposed within the opening and is in direct contact with the RDL pad.

Preferably, the UBM layer comprises an adhesion layer, a barrier layer and a wetting layer.

Preferably, a bump structure is disposed on the UBM layer.

Preferably, the bump structure comprises solder bumps, gold bumps, or copper pillar bumps.

Another aspect of the invention provides a semiconductor structure comprising a substrate, a passivation layer on the substrate, a first polymer layer on the passivation layer, a post-passivation interconnect (PPI) structure on the passivation layer, and a second polymer layer covering the PPI structure and the first polymer layer. The PPI structure comprises a step structure disposed on the first polymer layer and around a lower edge of the PPI structure.

Preferably, the step structure comprises a lower layer of the PPI structure that protrudes beyond a sidewall of the PPI structure on the first polymer layer.

Preferably, the lower layer comprises a titanium layer.

Preferably, the lower layer further comprises a copper on the titanium layer.

Preferably, the semiconductor structure further comprises an input/output (I/O) pad disposed on the substrate, wherein the passivation layer covers the substrate and a perimeter of the I/O pad.

Preferably, the PPI structure comprises a via portion disposed in the first polymer layer and in direct contact with the I/O pad, a RDL pad disposed over the first polymer layer and offset from the I/O pad, and a RDL runner extending on the first polymer layer between the via portion and the RDL pad.

Preferably, the PPI structure comprises a copper layer and a titanium layer under the copper layer.

Preferably, the passivation layer comprises silicon nitride.

Preferably, the first polymer layer and the second polymer layer comprise epoxy, polyimide, benzocyclobutene (BCB), or polybenzoxazole (PBO).

Preferably, an opening is formed in the second polymer layer to expose at least a portion of the RDL pad.

Preferably, an under-bump-metallurgy (UBM) layer is disposed within the opening and is in direct contact with the RDL pad.

Preferably, the UBM layer comprises an adhesion layer, a barrier layer and a wetting layer.

Preferably, a bump structure is disposed on the UBM layer.

Preferably, the bump structure comprises solder bumps, gold bumps, or copper pillar bumps.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:
FIG. 1 is a schematic, cross-sectional diagram showing an exemplary semiconductor structure with 1P2M scheme in accordance with one embodiment of the invention;
FIG. 2 is an enlarged view showing the step structure in FIG. 1 according to one embodiment of the invention;
FIG. 3 is an enlarged view showing the step structure in FIG. 1 according to another embodiment of the invention; and
FIG. 4 is a schematic, cross-sectional diagram showing an exemplary semiconductor structure with 2P2M scheme in accordance with still another embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the spirit and scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items.

The present disclosure pertains to a semiconductor structure such as a bumping structure on a semiconductor die or wafer, which utilizes 1P2M (1-polymer layer and 2-metal layer) or 2P2M (2-polymer layer and 2-metal layer) post-passivation scheme with stepped copper post-passivation interconnect (Cu-PPI) for stress reduction.

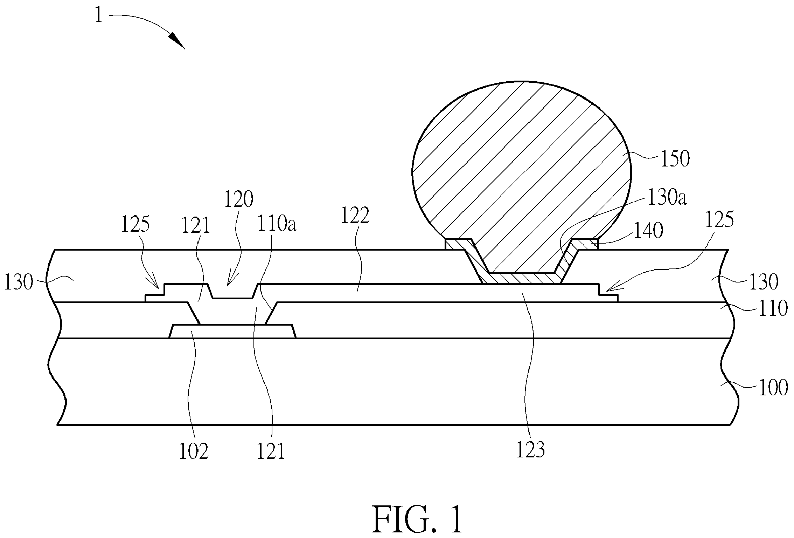

Please refer to FIG. 1. FIG. 1 is a schematic, cross-sectional diagram showing an exemplary semiconductor structure 1 with 1P2M scheme on a substrate 100 in accordance with one embodiment of the invention. As shown in FIG. 1, a substrate 100 such as a semiconductor substrate is provided. It is to be understood that the substrate 100 may comprise circuit elements such as transistors, interconnect structures such as wires or vias, and dielectric layers thereon. For the sake of simplicity, these circuit elements, interconnect structures and dielectric layers are not explicitly shown in the figures.

Preferably, the substrate 100 further comprises an input/output (I/O) pad 102. For example, the I/O pad 102 may be an aluminum pad, but not limited thereto. A passivation layer 110 covers the upper surface of the substrate 100 and the perimeter of the I/O pad 102. Preferably, an opening 110a is formed in the passivation layer 110 to expose a central surface region of the I/O pad 102. Preferably, the passivation layer 110 may comprise silicon nitride, silicon oxynitride, or the like.

Preferably, a patterned post-passivation interconnect (PPI) structure 120 is disposed on the I/O pad 102 and the passivation layer 110. Preferably, the PPI structure 120 may comprise a via portion 121 disposed in the opening 110a and in direct contact with the I/O pad 102, a redistribution layer (RDL) pad 123 disposed over the passivation layer 110 and offset from the I/O pad 102, and a RDL runner 122 extending on the passivation layer 110 between the via portion 121 and the RDL pad 123. Preferably, for example, the PPI structure 120 comprises a copper (Cu) layer. Preferably, for example, the PPI structure 120 may further comprise a titanium (Ti) layer under the copper layer.

Preferably, the semiconductor structure 1 further comprises a polymer layer 130 covering the PPI structure 120 and the passivation layer 110. Preferably, the polymer layer 130 may comprise epoxy, polyimide, benzocyclobutene (BCB), or polybenzoxazole (PBO), but not limited thereto. For example, the polymer layer 130 may be a polyimide layer. Preferably, an opening 130a is formed in the polymer layer 130 to expose at least a portion of the RDL pad 123.

Preferably, an under-bump-metallurgy (UBM) layer 140 is disposed within the opening 130a and is in direct contact with the RDL pad 123. The UBM layer 140 may comprise an adhesion layer, a barrier layer and a wetting layer, but not limited thereto. The UBM layer 140 may be formed of titanium, titanium nitride, titanium tantalum, titanium tantalum nitride, tungsten, titanium tungsten, nickel, gold, chrome, copper, or copper alloy. Any suitable materials or layers of material that may be used for the UBM are fully intended to be included within the scope of the current application.

Preferably, a bump structure 150 is disposed on the UBM layer 140. Preferably, for example, the bump structure 150 may comprise solder bumps, gold bumps, or copper pillar bumps, but not limited thereto.

Preferably, the PPI structure 120 further comprises a step structure 125 on the passivation layer 110 around the lower edge of the PPI structure 120. The step structure 125 comprises a lower layer of the PPI structure 120 that protrudes beyond a sidewall of the PPI structure 120 on the passivation layer 110. The step structure 125 disposed around the lower edge of the PPI structure 120 can effectively reduce the stress concentrated on the passivation layer 110 around the perimeter of the PPI structure 120. The stress may be induced from bulk copper RDL in thermal loading such as infrared (IR) reflow or temperature cycling test (TCT).

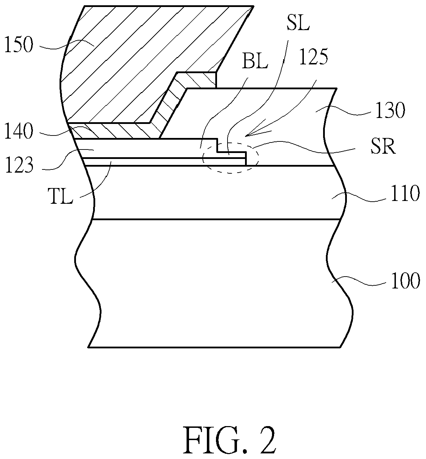

FIG. 2 is an enlarged view showing the step structure 125 in FIG. 1 according to one embodiment of the invention, wherein like regions, layers or materials are designated by like numeral numbers or labels. As shown in FIG. 2, the step structure 125 comprises a titanium layer TL and a copper layer SL, which protrudes beyond a sidewall of the PPI structure 120 on the passivation layer 110 and covers the stressed region SR. Preferably, the titanium layer TL may have a thickness that is less than 1.0 micrometer. Preferably, the copper layer SL may be a copper seed layer, but not limited thereto. Preferably, the copper layer SL may be an etched portion of the bulk copper layer BL.

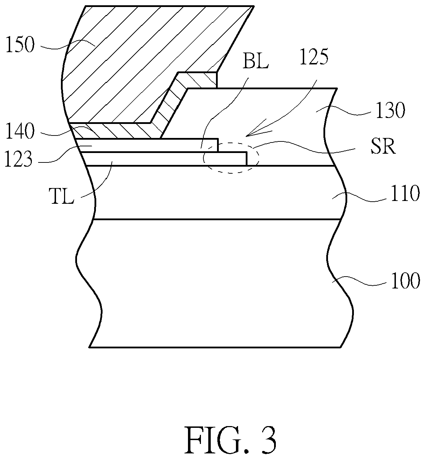

FIG. 3 is an enlarged view showing the step structure 125 in FIG. 1 according to another embodiment of the invention, wherein like regions, layers or materials are designated by like numeral numbers or labels. As shown in FIG. 3, the step structure 125 comprises only a titanium layer TL, which protrudes beyond a sidewall of the PPI structure 120 on the passivation layer 110 and covers the stressed region SR. Preferably, the titanium layer TL may have a thickness that is less than 1.0 micrometer.

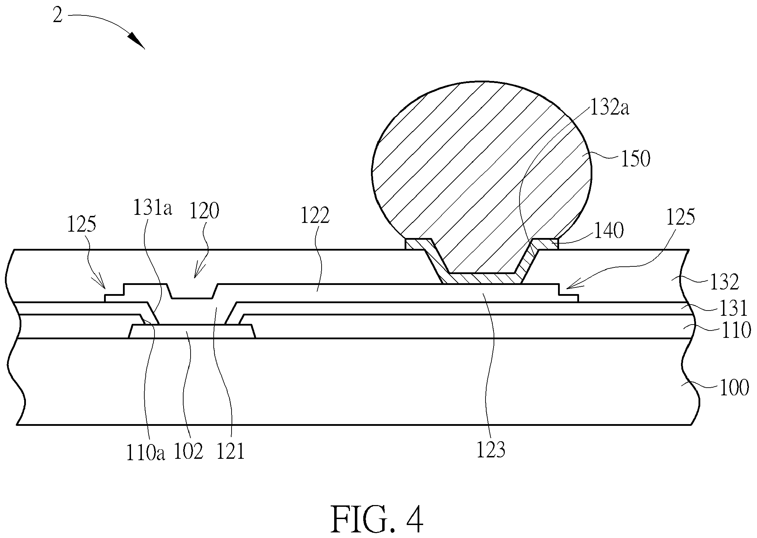

FIG. 4 is a schematic, cross-sectional diagram showing an exemplary semiconductor structure 2 with 2P2M scheme in accordance with still another embodiment of the invention, wherein like regions, layers or materials are designated by like numeral numbers or labels. As shown in FIG. 4, likewise, the semiconductor structure 2 is fabricated on a substrate 100 such as a semiconductor substrate. It is to be understood that the substrate 100 may comprise circuit elements such as transistors, interconnect structures such as wires or vias, and dielectric layers thereon. For the sake of simplicity, these circuit elements, interconnect structures and dielectric layers are not explicitly shown in the figures.

Preferably, the substrate 100 further comprises an I/O pad 102. For example, the I/O pad 102 may be an aluminum pad, but not limited thereto. A passivation layer 110 covers the upper surface of the substrate 100 and the perimeter of the I/O pad 102. Preferably, an opening 110a is formed in the passivation layer 110 to expose a central surface region of the I/O pad 102. Preferably, the passivation layer 110 may comprise silicon nitride, silicon oxynitride, or the like.

Preferably, a first polymer layer 131 is formed on the passivation layer 110. Preferably, the first polymer layer 131 may comprise epoxy, polyimide, benzocyclobutene (BCB), or polybenzoxazole (PBO), but not limited thereto. For example, the first polymer layer 131 is made of polyimide. The central surface region of the I/O pad 102 is revealed through an opening 131a in the first polymer layer 131.

Preferably, a patterned PPI structure 120 is disposed on the I/O pad 102 and the first polymer layer 131. Preferably, the PPI structure 120 may comprise a via portion 121 disposed in the opening 131a and in direct contact with the I/O pad 102, a RDL pad 123 disposed over the first polymer layer 131 and offset from the I/O pad 102, and a RDL runner 122 extending on the first polymer layer 131 between the via portion 121 and the RDL pad 123. Preferably, for example, the PPI structure 120 comprises a copper layer. Preferably, for example, the PPI structure 120 may further comprise a titanium layer under the copper layer.

Preferably, the semiconductor structure 2 further comprises a second polymer layer 132 covering the PPI structure 120 and the first polymer layer 131. Preferably, the second polymer layer 132 may comprise epoxy, polyimide, benzocyclobutene (BCB), or polybenzoxazole (PBO), but not limited thereto. For example, the second polymer layer 132 is made of polyimide. Preferably, an opening 132a is formed in the second polymer layer 132 to expose at least a portion of the RDL pad 123.

Preferably, an UBM layer 140 is disposed within the opening 132a and is in direct contact with the RDL pad 123. The UBM layer 140 may comprise an adhesion layer, a barrier layer and a wetting layer, but not limited thereto. The UBM layer 140 may be formed of titanium, titanium nitride, titanium tantalum, titanium tantalum nitride, tungsten, titanium tungsten, nickel, gold, chrome, copper, or copper alloy. Any suitable materials or layers of material that may be used for the UBM are fully intended to be included within the scope of the current application.

Preferably, a bump structure 150 is disposed on the UBM layer 140. Preferably, for example, the bump structure 150 may comprise solder bumps, gold bumps, or copper pillar bumps, but not limited thereto.

Preferably, the PPI structure 120 further comprises a step structure 125 on the first polymer layer 131 around the lower edge of the PPI structure 120. The step structure 125 comprises a lower layer of the PPI structure 120 that protrudes beyond a sidewall of the PPI structure 120 on the first polymer layer 131. The step structure 125 disposed around the lower edge of the PPI structure 120 can effectively reduce the stress concentrated on the first polymer layer 131 around the perimeter of the PPI structure 120. The stress may be induced from bulk copper RDL in thermal loading such as IR reflow or temperature cycling test.

The step structure 125 may comprise the titanium layer TL and the copper layer SL as set forth in FIG. 2. Preferably, the titanium layer TL may have a thickness that is less than 1.0 micrometer. Preferably, the copper layer SL may be a copper seed layer, but not limited thereto. Preferably, the copper layer SL may be an etched portion of the bulk copper layer BL. Alternatively, the step structure 125 comprises only the titanium layer TL as set forth in FIG. 3.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor structure (1), comprising:
a substrate (100);
a passivation layer (110) on the substrate (100);
a post-passivation interconnect, in the following also referred to as PPI, structure (120) on the passivation layer (110); and
a polymer layer (130) covering the PPI structure (120) and the passivation layer (110), wherein the PPI structure (120) comprises a step structure (125) disposed on the passivation layer (110) and around a lower edge of the PPI structure (120).

2. A semiconductor structure (2), comprising:
a substrate (100);
a passivation layer (110) on the substrate (100);
a first polymer layer (131) on the passivation layer (110);
a post-passivation interconnect, in the following also referred to as PPI, structure (120) on the first polymer layer (131); and
a second polymer layer (132) covering the PPI structure (120) and the first polymer layer (131), wherein the PPI structure (120) comprises a step structure (125) disposed on the first polymer layer (131) and around a lower edge of the PPI structure (120).

3. The semiconductor structure (1) according to claim 1, wherein the step structure (125) comprises a lower layer of the PPI structure (120) that protrudes beyond a sidewall of the PPI structure (120) on the passivation layer (110); or
the semiconductor structure (2) according to claim 2, wherein the step structure (125) comprises a lower layer of the PPI structure (120) that protrudes beyond a sidewall of the PPI structure (120) on the first polymer layer (131).

4. The semiconductor structure (1; 2) according to claim 3, wherein the lower layer comprises a titanium layer (TL).

5. The semiconductor structure (1; 2) according to claim 4, wherein the lower layer further comprises a copper (BL, SL) on the titanium layer (TL).

6. The semiconductor structure (1; 2) according to any one of the preceding claims, further comprising:
an input/output, in the following also referred to as I/O, pad (102) disposed on the substrate (100), wherein the passivation layer (110) covers the substrate (100) and a perimeter of the I/O pad (102).

7. The semiconductor structure (1) according to claim 6 that is directly or indirectly dependent on claim 1, wherein the PPI structure (120) comprises a via portion (121) disposed in the passivation layer (110) and in direct contact with the I/O pad (102), a redistribution layer, in the following also referred to as RDL, pad (123) disposed over the passivation layer (110) and offset from the I/O pad (102), and a RDL runner (123) extending on the passivation layer (110) between the via portion (121) and the RDL pad (123); or
the semiconductor structure (2) according to claim 6 that is directly or indirectly dependent on claim 2, wherein the PPI structure (120) comprises a via portion (121) disposed in the first polymer layer (131) and in direct contact with the I/O pad (102), a RDL pad (123) disposed over the first polymer layer (131) and offset from the I/O pad (102), and a RDL runner (123) extending on the first polymer layer (131) between the via portion (121) and the RDL pad (123).

8. The semiconductor structure (1; 2) according to any one of the preceding claims, wherein the PPI structure (120) comprises a copper layer (BL) and a titanium layer under the copper layer (TL).

9. The semiconductor structure (1; 2) according to any one of the preceding claims, wherein the passivation layer (110) comprises silicon nitride.

10. The semiconductor structure (1) according to claim 1 or any one of claims 3 to 9 that is directly or indirectly dependent on claim 1, wherein the polymer layer (130) comprises epoxy, polyimide, benzocyclobutene, in the following also referred to as BCB, or polybenzoxazole, in the following also referred to as PBO; or
the semiconductor structure (2) according to claim 2 or any one of claims 3 to 9 that is directly or indirectly dependent on claim 2, wherein the first polymer layer (131) and the second polymer layer (132) comprise epoxy, polyimide, benzocyclobutene, in the following also referred to as BCB, or polybenzoxazole, in the following also referred to as PBO.

11. The semiconductor structure (1) according to claim 1 or any one of claims 3 to 10 that is directly or indirectly dependent on claim 1, wherein an opening (130a) is formed in the polymer layer (130) to expose at least a portion of the RDL pad (123); or
the semiconductor structure (2) according to claim 2 or any one of claims 3 to 10 that is directly or indirectly dependent on claim 2, wherein an opening (132a) is formed in the second polymer layer (132) to expose at least a portion of the RDL pad (123).

12. The semiconductor structure (1; 2) according to claim 11, wherein an under-bump-metallurgy, in the following also referred to as UBM, layer (140) is disposed within the opening (130a; 132a) and is in direct contact with the RDL pad (123).

13. The semiconductor structure (1; 2) according to claim 12, wherein the UBM layer (140) comprises an adhesion layer, a barrier layer and a wetting layer.

14. The semiconductor structure (1; 2) according to claim 12 or 13, wherein a bump structure (150) is disposed on the UBM layer (140).

15. The semiconductor structure (1; 2) according to claim 14, wherein the bump structure (150) comprises solder bumps, gold bumps, or copper pillar bumps.
